# EUROPEAN PATENT APPLICATION

(11) **EP 1 217 702 A2**
(43) Date of publication of application: **26.06.2002**
(21) Application number: 01128006.2
(22) Date of filing: 24.11.2001
(51) Int. Cl.: H01S 5/183

(54) **Semiconductor light-emitting device with improved electro-optical characteristics and method of manufacturing the same**

(30) Priority: 19.12.2000 KR 2000078543
(71) Applicant: SAMSUNG ELECTRONICS CO., LTD., Suwon-City, Kyungki-do (KR)
(72) Inventor: Chang, Dong-hoon, Anyang-si, Gyeonggi-do (KR)
(74) Representative: Parkinson, Neil Scott

(57) **Abstract**

A semiconductor light-emitting device having a resonant cavity structure for emitting light perpendicularly to the plane of an active region, and a method of manufacturing the same are provided. A post has a window (25a) of an upper electrode (36) and a current aperture (17) of an oxidized layer (18). Resonated light is emitted through the window (25a) and the current aperture (17). The post is formed by performing etching by way of self-alignment using the upper electrode (36) so that the central axis (46) of the window (25a) and the central axis (46) of the current aperture (17) can be automatically aligned. During the etching process, the sidewall of a pre-oxidized layer (17) included in the post is exposed, and the pre-oxidized layer (17) is horizontally oxidized by an oxidizing process by a predetermined distance from the sidewall thereof. The pre-oxidized layer (17) oxidized by the oxidizing process becomes a high-resistance portion (18), and the pre-oxidized layer (17) unoxidized during the oxidizing process becomes a current aperture (17) through which current or light passes.

## Description

The present invention relates to a semiconductor light-emitting device having a resonant cavity structure for emitting light perpendicularly to the plane of an active region and a method of manufacturing the same, and more particularly, although not exclusively, to a semiconductor light-emitting device in which the central axis of an upper electrode window, through which resonated light is emitted, and the central axis of a current aperture of an oxidized layer are automatically aligned, and a method of manufacturing the same.

Semiconductor light-emitting devices, first developed by General Electric (GE) in 1962, are designed to recombine electrons with holes by applying forward current across a PN junction in a compound semiconductor and to generate light having a wavelength corresponding to band gap energy determined according to the structure of the semiconductor.

Semiconductor light-emitting devices are divided according to the process by which they emit light, into light emitting diodes, which emit incoherent light using spontaneous emission and semiconductor lasers, which emit coherent light using stimulated emission.

Semiconductor lasers are divided according to the positions of reflectors, into Fabry-Perot semiconductor lasers in which reflectors are positioned at opposite sides of a chip, and Vertical Cavity Surface Emitting Lasers (VCSELs) having a resonant cavity structure in which reflectors are horizontally positioned within a chip.

VCSELs do not need an optical system for correcting the shape of a beam because they emit a nearly circular Gaussian beam in a direction in which semiconductor material layers are stacked. In addition, since the size of VCSELs is small, a plurality of lasers can be integrated on a single semiconductor wafer. Therefore, VCSELs have a wide range of optical applications such as optical communication, electronic calculators, audio-video devices, laser printers, laser scanners and medical instruments.

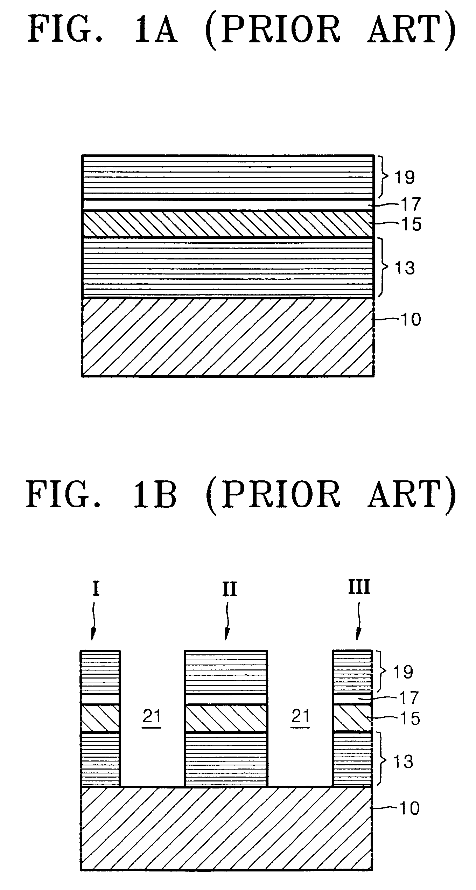

FIGS. 1A through 1E show a conventional method of manufacturing a VCSEL. As shown in FIG. 1A, a lower reflector layer 13, an active layer 15, a pre-oxidized layer 17, and an upper reflector layer 19 are sequentially stacked on a substrate 10'. Here, the substrate 10' is formed of, for example, a semiconductor material containing n-type impurities. The lower reflector layer 13 is doped with impurities of the same type as the substrate 10 and is formed, for example, by stacking 20-30 layers of n-type GaAs, in which the ratio of Ga to As is different in each layer, on the substrate 10'. The upper reflector layer 19 is formed of the same semiconductor material as the lower reflector layer 13 but contains the opposite type of impurities to those contained in the lower reflector layer 13. In other words, the upper reflector layer 19 is formed of p-type GaAs. The pre-oxidized layer 17 is subjected to a horizontal oxidation process in vapor.

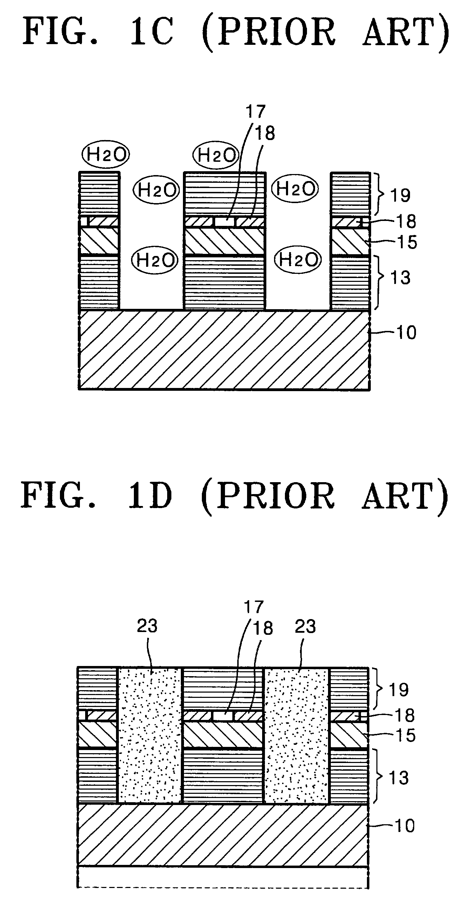

Thereafter, as shown in FIG. 1B, a dry etching process is performed to form spaces 21, thereby forming a plurality of VCSEL posts I, II and III on the substrate 10 through each of which light will be independently radiated. When an oxidation atmosphere is formed after the spaces 21 are formed, the pre-oxidized layer 17 is oxidized horizontally from its outside to its inside, thereby forming a horizontally oxidized high-resistance portion 18 and a current aperture 17 which is not oxidized, as shown in FIG. 1C.

Subsequently, as shown in FIG. 1D, the spaces 21 are filled with polyimide 23 in order to prevent posts from being damaged during a lapping process on the substrate 10'. Then, the polyimide 23 filling the spaces 21 is planarized to be level with the surroundings. Thereafter, the resultant structure is turned over and most of the substrate 10 is removed by a lapping process.

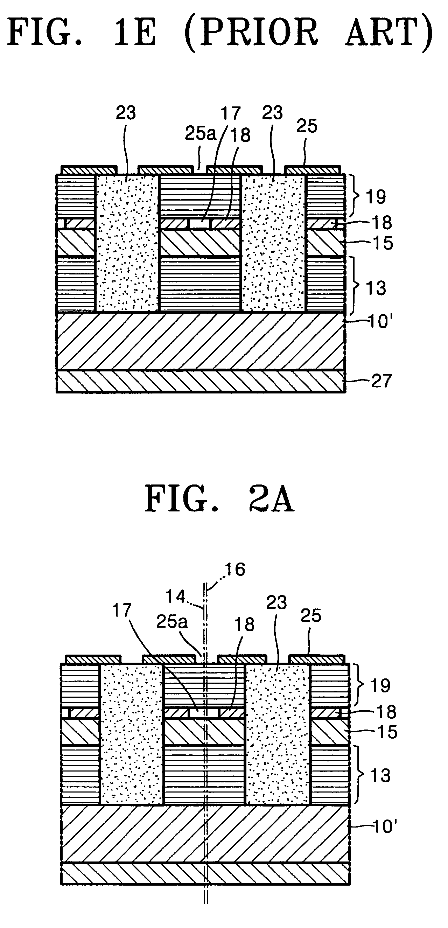

Next, as shown in FIG. 1E, an upper electrode 25 having a window 25a is formed on the VCSEL posts I, II and III and the polyimide 23, and a lower electrode 27 is formed on the bottom surface of a lapped substrate 10', thereby completing the manufacture of a VCSEL. VCSELs having the above structure may be used as a single chip array structure, or may be cut at each polyimide portion so as to be used separately.

As shown in FIG. 2A, as a consequence of the conventional manufacturing technique, the current aperture 17 formed by a horizontal oxidation process after posts are formed, and the window 25a of the upper electrode 25 formed by a photolithographic process, are not exactly aligned as a consequence of the processes. Consequently an alignment error occurs, in which the central axis 16 of the window 25a and the central axis 14 of the aperture 17 deviate from each other. Such an alignment error results in a loss of emitted light and hinders formation of an exact Gaussian beam, thereby degrading the electro-optical characteristics of a VCSEL.

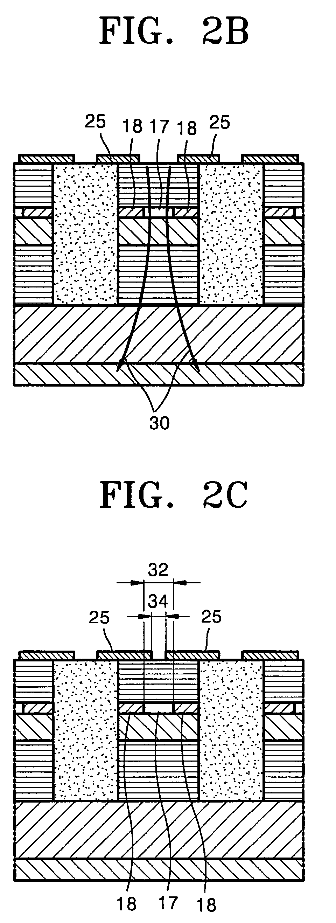

So as to take into account the alignment error that can occur during the manufacturing process, a VCSEL may be designed by way of "electrode pulling" in which upper electrodes 25 are formed beyond the region of the current aperture 17 between high-resistance portions 18, as shown in FIG. 2B. However, in this case, the current path 30 is lengthened, thereby increasing overall device resistance. Alternatively, if designed according to "electrode pushing" in which upper electrodes 25 are formed to extend over a current aperture 17 between high-resistance portions 18, as shown in FIG. 2C, an upper electrode window size 34 is formed smaller than a current aperture size 32, so a loss of emitted light occurs.

Therefore, it is advantageous to exactly align the central axis of an upper electrode window and the central axis of a current aperture.

It is an aim of preferred embodiments of the present invention to provide a semiconductor light-emitting device with improved electro-optical characteristics by more precisely aligning the central axis of an upper electrode window and the central axis of a current aperture, and a method of manufacturing the same.

In a first aspect, the present invention provides a semiconductor light-emitting device having a post which is composed of a plurality of layers (13, 15, 17, 19) including at least one pre-oxidized layer (17) on a substrate (10), and an electrode (36) on the post, characterized in that the semiconductor light-emitting device is manufactured by forming the post by performing etching by way of self-alignment using the electrode (36), and horizontally oxidizing the pre-oxidized layer (17) a predetermined distance from a sidewall of the post.

The post is formed by performing etching by way of self-alignment using the electrode in order to align the central axes of the respective electrode window and the current aperture, which are formed within the post.

During the etching process, the sidewall of a pre-oxidized layer included in the post is exposed, and the pre-oxidized layer is horizontally oxidized by an oxidizing process by a predetermined distance from the sidewall thereof. For example, when the diameter of the post is about 60 µm, about 45-50 µm of the pre-oxidized layer is oxidized. A portion of the pre-oxidized layer oxidized by the oxidizing process becomes a high-resistance portion, and a portion of the pre-oxidized layer unoxidized during the oxidizing process becomes a current aperture through which current or light passes. Since the post is formed by way of self-alignment using the electrode, and the current aperture is formed by oxidizing the exposed sidewall of the post, the central axis of the window of the electrode and the central axis of the current aperture are automatically aligned. Therefore, due to the exact alignment between the window and the current aperture, the electro-optical characteristics of the Vertical Cavity Surface Emitting Laser (VCSEL) are improved.

The window of the electrode is passivated by photoresist in order to avoid damage occurring during etching performed by way of self-alignment using the electrode. Simultaneously, the surface of the electrode is partially or entirely passivated by the photoresist. When the surface of the electrode is partially passivated, even if a portion of the electrode exposed during the etching process is damaged, the remaining portion of the electrode protected by the photoresist is sufficient to demonstrate conductivity as an electrode.

In another aspect, the present invention provides a method of manufacturing a semiconductor light-emitting device including a substrate (10) and a lower reflector layer (13), an active layer (15), a pre-oxidized layer (17), and an upper reflector layer (19) which are sequentially formed on the surface of the substrate (10) characterized in that the method comprises the steps of:
patterning an upper electrode (36) having a window (25a) on the upper reflector layer (19);
forming photoresist (38) on a portion of the upper electrode (36) including the window (25a);
performing an etching process using the upper electrode (36) and the photoresist (38) as a mask until the pre-oxidized layer (17) is exposed, thereby forming a post;
oxidizing a portion of the pre-oxidized layer (17); and
filling an etched portion resulting from the etching process with a buffer material (42) and forming a lower electrode (27) on the bottom of the substrate (10).

In a further aspect, the present invention provides a method of manufacturing a semiconductor light-emitting device including a substrate (10) and a lower reflector layer (13), an active layer (15), a pre-oxidized layer (17), and an upper reflector layer (19) which are sequentially formed on the surface of the substrate (10), characterized in that the method comprises the steps of:
patterning an upper electrode (36) having a window (25a) on the upper reflector layer (19);
forming photoresist (38) on the entire surface of the upper electrode (36) including the window (25a);
performing an etching process using the upper electrode (36) photoresist (38) as a mask until the pre-oxidized layer (17) is exposed, thereby forming a post;
oxidizing a portion of the pre-oxidized layer (17); and
filling an etched portion resulting from the etching process with a buffer material (42) and forming a lower electrode (27) on the bottom of the substrate (10).

For a better understanding of the invention, and to show how embodiments of the same may be carried into effect, reference will now be made, by way of example, to the accompanying diagrammatic drawings in which:
FIGS. 1A through 1E are sectional views of stages in the process of manufacturing a Vertical Cavity Surface Emitting Laser (VCSEL) according to a conventional technique;
FIG. 2A is a sectional view of a misaligned VCSEL manufactured by the method shown in FIGS. 1A through 1E;
FIG. 2B is a sectional view of a VCSEL having an electrode pulling structure;
FIG. 2C is a sectional view of a VCSEL having an electrode pushing structure; and
FIGS. 3A through 3G are sectional views of stages in the process of manufacturing a VCSEL according to an embodiment of the present invention.

Hereinafter, an embodiment of the present invention will be described in detail with reference to the attached drawings. The technical features of the present invention will be more easily understood by way of example only through the following description. In the drawings, the same reference numerals denote the same member.

FIG. 3A shows a stacked semiconductor structure used for manufacturing a semiconductor light-emitting device (hereinafter, referred to as a Vertical Cavity Surface Emitting Laser (VCSEL)) according to a preferred embodiment of the present invention. The VCSEL has a stacked semiconductor structure in which light is emitted in a direction perpendicular to the plane of a layer. Such a stacked semiconductor structure is formed by epitaxial deposition such as Metal-Organic Chemical Vapor Deposition (MOCVD), Liquid Phase Epitaxy (LPE), Molecular Beam Epitaxy (MBE), or other well-known crystal growth methods.

As shown in FIG. 3A, the stacked semiconductor structure includes a substrate 10, a lower reflector layer 13, an active layer 15, a pre-oxidized layer 17, and an upper reflector layer 19, from the bottom to the top.

The substrate 10 prepared first in manufacturing a VCSEL is, for example, an n-type GaAs substrate having a high concentration of impurities. The impurity concentration is, for example, 5x10¹⁸cm⁻³. The GaAs substrate facilitates epitaxial deposition of AlGaAs or AlAs as will be described later.

The lower reflector layer 13 is formed on the substrate 10. As occasion demands, a semiconductor buffer layer such as a GaAs thin film of about 0.5 µm which can be epitaxially deposited on the substrate 10 may be formed before the lower reflector layer 13 is formed.

The lower reflector layer 13 is formed of a distributed Bragg reflector (DBR) having the same conductivity as the substrate 10, that is, an n-type, in a superlattice structure. The lower reflector layer 13 is formed on the substrate 10 by epitaxial deposition such as MOCVD and/or MBE. The lower reflector layer 13 performs internal reflection in a VCSEL structure. In the lower reflector layer 13, a plurality of AlₓGa₁₋ₓAs layers and a plurality of Al_{y}Ga_{1-y}As layers are alternately stacked. Each Al_{y}Ga_{1-y}As layer has a low aluminium content of, for example, about 10%, so that it usually has a predetermined refractive index. Each AlₓGa₁₋ₓAs layer has a high aluminium content of, for example, about 95%. Preferably, each alternating layer constituting the lower reflector layer 13 has an effective optical thickness of about 1/4 of a wavelength of light generated by the VCSEL. It is preferable that the lower reflector layer 13 has a reflectance of about 100% as a whole, if possible, in order to achieve high internal reflection in the VCSEL. As is well known, the reflectance of the lower reflector layer 13 depends on a difference in the refractive index between AlₓGa₁₋ₓAs and Al_{y}Ga_{1-y}As and the number of pairs of AlₓGa₁₋ₓAs and Al_{y}Ga_{1-y}As in the lower reflector layer 13. Accordingly, as the difference in refractive index and the number of pairs of alternating layers increase, higher reflectance can be obtained.

The active layer 15 is formed on the lower reflector layer 13 by epitaxial deposition. The active layer 15 includes at least one quantum well layer, a barrier layer surrounding the quantum well layer, and a cladding layer surrounding the barrier layer. Here, it is preferable that the barrier layer has a middle energy band gap between the energy band gap of the quantum well layer and the energy band gap of the cladding layer. The active layer 15 is designed to provide sufficient optical gain to the VCSEL. For example, in order to manufacture a VCSEL for emitting light having a wavelength of 980 nanometers, the active layer 15 is formed by alternately stacking three quantum well layers of In_{0.2}Ga_{0.8}As each having a thickness of 8 nanometers and barrier layers of GaAs each having a thickness of 10 nanometers and surrounding each quantum well layer, and forming cladding layers of Al_{0.5}Ga_{0.8}As so that the stack of quantum well layers and barrier layers are sandwiched between the cladding layers. In the drawings, a quantum well layer, a barrier layer, and a cladding layer are not discriminated but are illustrated as a single layer in order to simplify the drawings.

The pre-oxidized layer 17 is formed on the active layer 15 by epitaxial deposition. The pre-oxidized layer 17 is doped with the same type of dopant as the nearest reflector layer. Since the pre-oxidized layer 17 is positioned between the active layer 15 and the upper reflector layer 19, preferably the pre-oxidized layer 17 is doped with the same type of dopant as the upper reflector layer 19. For example, the pre-oxidized layer 17 is doped with a p-type dopant at concentration of about 10¹⁸cm⁻³. In addition, the pre-oxidized layer 17 includes posts and a semiconductor alloy containing aluminium, for example, AlAs or AlGaAs, which can be partially oxidized after a post is formed. Therefore, an oxidized portion will increase in resistance, and an unoxidized portion will pass current and light as a current aperture. The pre-oxidized layer 17 is oxidized starting from the sidewall of each post formed by the etching process, toward the inside so that an oxidized portion usually has a circular shape. Here, the shape of the oxidized portion will depend on the shape of the post and the number of sidewalls exposed in an oxidizing process. The shape of an oxidized portion can be influenced or controlled by the composition of a semiconductor alloy contained in the pre-oxidized layer 17, the orientation of the alloy, the thickness of the pre-oxidized layer 17, and the conditions of the oxidizing process. For example, during an oxidizing process, aqueous vapor contained in N₂ carrier gas oxidizes AlAs at a temperature of 400-500°C, thereby forming aluminium oxide.

Typically, AlAs containing 100% Al is oxidized by about 1.5 µm per minute at 450°C, and AlGaAs containing 80% Al is oxidized by about 0.01 µm per minute. U.S. Patent Nos. 5,262,360 and 5,373,522 issued to Holonyak, Jr. et al. and U.S. Patent No. 5,493,577 issued to Choquette et al. can be referred to for more details about the shape of an oxidized portion and the conditions of a proper process.

The upper reflector layer 19 is formed on the pre-oxidized layer 17 by epitaxial deposition. Like the lower reflector layer 13, the upper reflector layer 19 is formed by alternately stacking a plurality of AlₓGa₁₋ₓAs layers and a plurality of Al_{y}Ga_{1-y}As layers. However, the upper reflector layer 19 is doped with impurities of a different conductivity than the lower reflector layer 13. In other words, when the lower reflector layer 13 and the substrate 10 are doped with an n-type dopant, the upper reflector layer 19 is preferably doped with a p-type dopant. In addition, the upper reflector layer 19 is designed to have a smaller number of layers than the lower reflector layer 13 in order to reduce its reflectance to allow the VCSEL to emit light. The preferred upper reflector layer 19 usually has a reflectance of 98-99%.

The active layer 15 and the pre-oxidized layer 17 are sandwiched between the lower reflector layer 13 and the upper reflector layer 19. Therefore, the upper reflector layer 19 and the lower reflector layer 13 form a resonant surface for resonating light generated from the active layer 15.

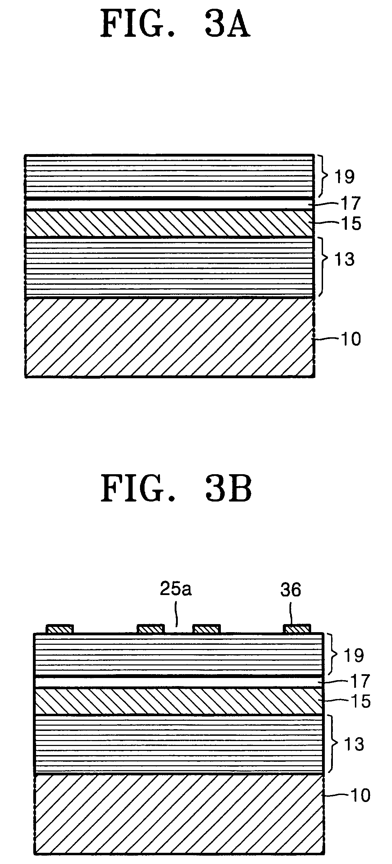

As shown in FIG. 3B, an upper electrode 36 is formed on the upper reflector layer 19 of the resultant structure of FIG. 3A. The upper electrode 36 is formed by depositing, for example, AuBe/Ti/Au metal or Cr/Au metal on the p-type upper reflector layer 19, and has a window 25a formed at a predetermined position by a photolithographic masking process or a lift-off process.

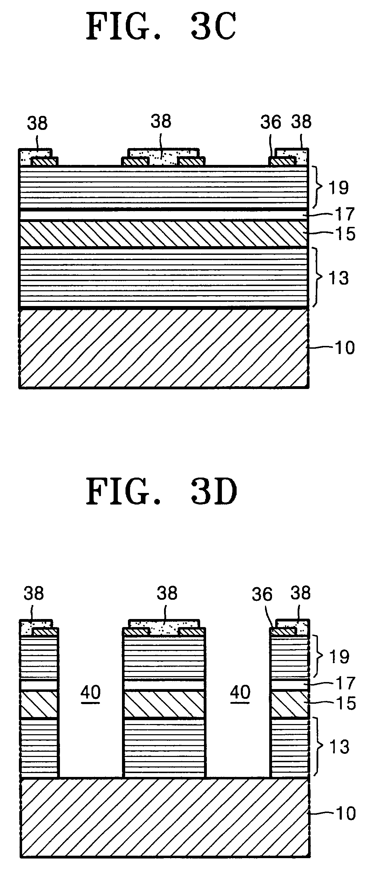

After the window 25a of the upper electrode 36 is formed, photoresist 38 is patterned around the window 25a, as shown in FIG. 3C. It is preferable that the photoresist 38 is blanket-deposited over the upper electrode 36 and the window 25a, because an exposed upper electrode is likely to be damaged during a later etching process. However, it will be fine even if a part of an electrode is exposed, as shown in FIG. 3C, taking into account an error in patterning photoresist because the remaining part of the electrode is sufficiently protected by the photoresist to maintain conductivity as an electrode.

As shown in FIG. 3D, an etching process is performed using the upper electrode 36 and the photoresist 38 as a mask, thereby forming spaces 40 and posts of a mesa type. Through such a process of forming posts, edges of the stacked materials are exposed. Wet or dry etching performs the post forming process. It is preferable to use dry etching such as reactive ion etching (RIE) in order to obtain a sidewall of accurate depth and uniform surface. RIE is disclosed in detail in U.S. Patent No. 5,034,092, entitled "Plasma Etching of Semiconductor Substrates", issued 23 July 1991. Alternatively, besides RIE, various types of dry etching, for example, Reactive Ion Beam Etching (RIBE), Chemically Assisted Ion Beam Etching (CAIBE), and Ion Beam Activated Gas Surface Chemistry (IBAGSC) (refer to U.S. Patent No. 5,116,461, entitled "Method for Fabricating an Angled Diffraction Grating", issued 26 May 1992) can be used.

During such a post forming process, an accurate etching depth can be provided by an in-situ process using a reflected light measuring apparatus, and the etching process can be stopped after the pre-oxidized layer 17 is etched downward.

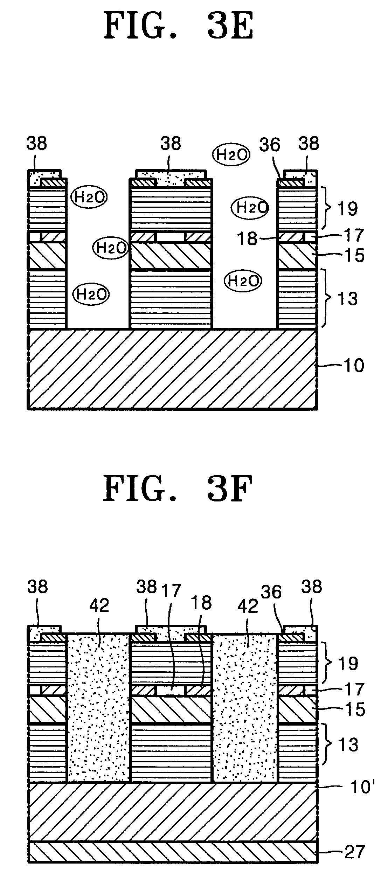

After the posts are formed as shown in FIG. 3D, an oxidizing process is performed on the pre-oxidized layer 17 formed of, for example, AlAs, as shown in FIG. 3E. Such an oxidizing process was proposed for the first time in U.S. Patent No. 5,262,360, issued to Holonyak, Jr. et al., entitled "AlGaAs Native Oxide", filed 24 June 1991 and patented 16 November 1993. In U.S. Patent No. 5,262,360, an aluminum-containing Group III-V semiconductor material is exposed to a water-containing environment at a temperature of about 375°C to convert at least a portion of the aluminium-containing material into a native oxide.

U.S. Patent No. 5,373,522 issued to Holonyak, Jr. et al., entitled "Semiconductor Devices with Native Aluminium Oxide Regions", filed 7 September 1993 and patented 13 December 1994, claims the structure of a semiconductor laser using the oxidizing method disclosed in U.S. Patent No. 5,262,360. In U.S. Patent No. 5,373,522, a native oxide formed from aluminium according to U.S. Patent No. 5,262,360 is used as a current blocking layer within a semiconductor laser.

Meanwhile, in U.S. Patent No. 5,493,577 issued to Choquette et al., entitled "Efficient Semiconductor Light Emitting Device and Method", filed 21 December 1994 and patented 20 February 1996, a current blocking layer formed according to U.S. Patent No. 5,373,522 is used in a VCSEL structure. The structure and effects of a VCSEL employing a current blocking layer were introduced by Choquette ["Selectively Oxidized Vertical-Cavity Laser Performance and Technology", IEEE, pp. 283-288, 1998].

The selective oxidizing process performed in the preferred embodiment and the current aperture formed by the selective oxidizing process are based on the above documents.

In other words, a selective oxidizing process is performed by positioning a VCSEL wafer in a container and heating the wafer in a controlled environment maintaining a high percentage of humidity, preferably, at a temperature of 350-500°C, and more preferably, at a temperature of 400-450°C. Here, the pre-oxidized layer 17 is horizontally oxidized from the sidewall of each etched post toward the center of the post. Meanwhile, the layers other than the pre-oxidized layer 17 in the stack structure are not oxidized because their aluminium content is small.

An oxidized portion 18 of the pre-oxidized layer 17 subjected to the selective etching method usually has a circular shape, electrically high resistance or insulation, and a low refractive index of about 1.6. An unoxidized portion 17 of the pre-oxidized layer 17 becomes a passage through which light is emitted and a current aperture through which electric current flows. The oxidized portion 18 surrounding the current aperture has a donut shape when viewed from above the post.

When electric current passes through the current aperture, i.e., the unoxidized portion 17, and reaches the center of the active layer 15, the density of carriers in the active layer 15 increases due to this current channelling, thereby increasing the efficiency of generating light.

After the current aperture is formed by an oxidizing process as described above, spaces around the post are filled with polyimide 42, as shown in FIG. 3F. The polyimide 42 minimizes damage to the post during the process of lapping the substrate 10.

After filling the polyimide 42, the bottom of the substrate 10 is lapped in order to facilitate cutting of the wafer.

A lower electrode 27 is formed by depositing patterned AuGe/Ni/Au on the entire bottom surface of the lapped substrate 10' or by blanket-metalizing the bottom surface of the lapped substrate 10'. The lower electrode 27 is annealed together with the upper electrode 36, thereby becoming an electrode portion of the VCSEL.

The lower electrode 27 includes opaque metals or semitransparent metals. For example, the lower electrode 27 has a multi-layer structure including AuGe having a thickness of about 800Å, Ni having a thickness of about 200 Å and Au having a thickness of about 400Å.

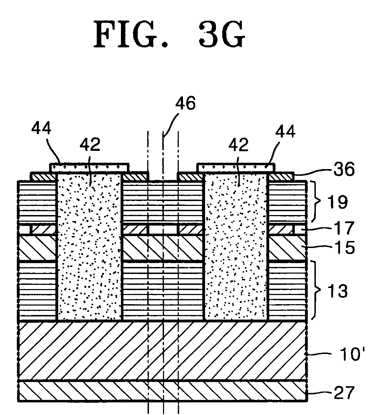

After forming the lower electrode 27 on the lapped substrate 10', as shown in FIG. 3F, a wire bonding pad 44 is formed on the upper electrode 36 that has been used as a mask to form the post, thereby completing a VCSEL array, as shown in FIG. 3G.

VCSELs manufactured through the above steps may be used as a single chip array structure or may be cut at each polyimide portion to be used separately.

According to conventional technology, a post is formed first, and then a window of an upper electrode is formed to correspond to a current aperture formed by oxidizing a pre-oxidized layer, so it is difficult to align the central axis of the window of the upper electrode and the central axis of the current aperture. As a result, an alignment error occurs, thereby deteriorating the electro-optical characteristics of a VCSEL.

In contrast, the preferred embodiment forms an upper electrode first, forms a post by performing an etching process using the upper electrode, and forms a current aperture using an oxidizing process, so the central axis of the window of the upper electrode and the central axis of the current aperture are self-aligned. Accordingly, such a VCSEL has improved electro-optical characteristics due to the exact alignment between the central axis of a window of an upper electrode and the central axis of a current aperture, compared to a conventional VCSEL.

The embodiment of forming a post by performing etching by way of self-alignment using an upper electrode has been described, but the present invention should not be construed as being limited to this embodiment. It should be understood that various changes may be made in the embodiment without departing from the scope of the invention as defined by the appended claims.

For example, while a VCSEL having a single current aperture on an active layer within a post has been described above, at least one current aperture can be formed above and/or below the active layer in order to control the optical characteristics of the VCSEL.

While the embodiment of the present invention has been described with reference to a method of manufacturing a post having a circular shape when viewed in a direction in which light is emitted from a VCSEL to achieve circular light emission, the present invention can be applied to a post having a rectangular, square, elliptical, or other shape, rather than a circular shape according to the use of emitted light.

While photoresist is formed on a part or on the entire surface of an electrode and is then etched to form a post in the above-described embodiment of the present invention, the etching process may be performed after sidewalls are formed at both opposite ends of the electrode.

While a material of each layer and a method of forming the layer are specified in the above description of an embodiment of the present invention, the present invention is not limited thereto. It will be understood by those skilled in the art that various materials or methods can be used within the scope of the invention.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A semiconductor light-emitting device having a post which is composed of a plurality of layers (13, 15, 17, 19) including at least one pre-oxidized layer (17) on a substrate (10), and an electrode (36) on the post, **characterized in that** the semiconductor light-emitting device is manufactured by forming the post by performing etching by way of self-alignment using the electrode (36), and horizontally oxidizing the pre-oxidized layer (17) by a predetermined distance from a sidewall of the post.

2. The semiconductor light-emitting device of claim 1, wherein the post comprises a lower reflector layer (13), an active layer (15), a pre-oxidized layer (17), and an upper reflector layer (19) which are formed by epitaxial deposition on the substrate (10).

3. The semiconductor light-emitting device of claim 1 or 2, wherein the semiconductor light-emitting device is a vertical cavity surface emitting laser which emits light perpendicularly to the plane of a stacked layer.

4. The semiconductor light-emitting device of claim 1 or 2, wherein a portion of the pre-oxidized layer (17) is horizontally oxidized, thereby forming a high-resistance portion (18), and an unoxidized portion becomes a current aperture (17) through which current or light passes.

5. A method of manufacturing a semiconductor light-emitting device including a substrate (10) and a lower reflector layer (13), an active layer (15), a pre-oxidized layer (17), and an upper reflector layer (19) which are sequentially formed on the surface of the substrate (10), **characterised in that** the method comprises the steps of:
Patterning an upper electrode (36) having a window (25a) on the upper reflector layer (19);
forming photoresist (38) on a portion of the upper electrode (36) including the window (25a);
performing an etching process using the upper electrode (36) and the photoresist (38) as a mask until the pre-oxidized layer (17) is exposed, thereby forming a post;
oxidizing a portion of the pre-oxidized layer (17); and
filling an etched portion resulting from the etching process with a buffer material (42) and forming a lower electrode (27) on the bottom of the substrate (10).

6. A method of manufacturing a semiconductor light-emitting device including a substrate (10) and a lower reflector layer (13), an active layer (15), a pre-oxidized layer (17), and an upper reflector layer (19) which are sequentially formed on the surface of the substrate (10), **characterized in that** the method comprises the steps of:
patterning an upper electrode (36) having a window (25a) on the upper reflector layer (19);
forming photoresist (38) on the entire surface of the upper electrode (36) including the window (25a) ;
performing an etching process using the photoresist (38) as a mask until the pre-oxidized layer (17) is exposed, thereby forming a post;
oxidizing a portion of the pre-oxidized layer (17); and
filling an etched portion resulting from the etching process with a buffer material (42) and forming a lower electrode (27) on the bottom of the substrate (10).

7. A semiconductor light-emitting device manufactured according to claim 5 or 6.
